# EUROPEAN PATENT APPLICATION

(11) **EP 3 059 599 A1**
(43) Date of publication of application: **24.08.2016**
(21) Application number: 13895726.1
(22) Date of filing: 28.10.2013
(51) Int. Cl.: G01R 31/36, G01R 31/34, H01M 10/48

(54) **POWER MONITORING SYSTEM FOR BATTERY OF TRANSMISSION**

(30) Priority: 18.10.2013 KR 20130124650; 18.10.2013 KR 20130124651
(71) Applicant: Maroomcs Co. Ltd, Cheongju-si, Chungcheongbuk-do 361-540 (KR)
(72) Inventor: KANG, Yun Jeong, Cheongju-si, Chungcheongbuk-do 361-815 (KR); HAN, Yeon Soo, Cheongju-si, Chungcheongbuk-do 361-819 (KR)
(74) Representative: Zacco Sweden AB
(86) International application number: PCT/KR2013/009622
(87) International publication number: WO 2015/056830

(57) **Abstract**

The present invention provides a power monitoring system for a battery of an electro-mechanical apparatus, including: a measuring part measuring a characteristic value of each of a plurality of cells of the battery; a central processing part calculating an evaluation target value from the characteristic value and calculating a state information of the battery and a driving information of the electro-mechanical apparatus by comparing the evaluation target value and a first reference value; a wireless communicating part transmitting the state information and the driving information to an external management system; and a storing part storing the first reference value, the state information and the driving information

## Description

### [Technical Field]

The present invention relates to a power monitoring system, more particularly, to a power monitoring system for a battery of an electro-mechanical apparatus including a plurality of cells and a power monitoring method.

### [Background Art]

A battery for an electro-mechanical apparatus is a kind of a secondary cell. The battery includes a combination of a plurality of cells each including an anode plate, a cathode plate and an electrolyte between the anode plate and the cathode plate. The battery has been widely used for supplying a power in the electro-mechanical apparatus such as a car, an electric cart and an electronic forklift.

The battery is consistently used with repeating a charging and a discharging. During the charging, a power is generated by using a chemical energy due to a chemical reaction between the anode plate and the cathode plate in the electrolyte. During the discharging, the electrolyte is sulfated due to an electric energy supplied from an exterior.

Since the battery is used as a main power source of the electro-mechanical apparatus, movement of the electro-mechanical apparatus becomes impossible when the battery has a problem in function.

Accordingly, it is important for stable utilization of the electro-mechanical apparatus to preliminarily prevent a problem in function by periodically checking performance and expectancy life of the battery. However, a power monitoring system according to the related art does not satisfy an accuracy required by a user.

The battery for the electro-mechanical apparatus has a great difference in discharging amount of an electric energy according to a temperature by the nature of using an electric energy converted from a chemical energy.

For example, the discharging amount at the temperature of -17.8°C may be about 50% of the discharging amount at the temperature of 25°C, and the terminal voltage at the temperature of -17.8°C is reduced as compared with the terminal voltage at the temperature of 25°C.

In addition, when the temperature is higher than 25°C, although the greater energy is discharged, the lifetime of the battery is shortened.

Due to the above-mentioned temperature property, in a place which has four seasons or a great temperature change like Korea, the state of the battery is judged based on a temperature of an external air or a temperature of the battery.

For example, when the battery for a cart of a golf course is judged as poor by measuring only the terminal voltage at a temperature lower than 0°C, the battery which can be normally used at a temperature higher than 0°C may be discarded.

In a golf course of Korea, the battery which cannot be used for 18 holes in a midwinter is generally used till the next autumn after passing the winter.

TABLE 1 illustrates a relation between a cell terminal voltage and a discharging amount (capacity) according to a temperature when a fully charged battery (280AH/5HR) is discharged with a load (56A).

In TABLE 1, although a deviation of a terminal voltage (open V) at an initial state of discharging is within a range of about 0.01 to about 0.01V according to an external temperature, the deviation of the terminal voltage increases up to about 0.13V when a load is added (discharging state). As a result, when the state of the battery is judged based on a maximum terminal voltage, a minimum terminal voltage or a deviation between the maximum terminal voltage and the minimum terminal voltage at a discharging state, the judgment on the battery may have a problem at a relatively low temperature.

**[TABLE 1]**

| external temperature (°C) | open V | after 30min | after 60min | after 90min | after 120min | ... | end V | end time | discharge magnitude |
|---|---|---|---|---|---|---|---|---|---|
| 25 | 2.12 | 1.98 | 1.98 | 1.96 | 1.94 | | 1.75 | 4:56 | 276.3 |
| 0 | 2.09 | 1.94 | 1.92 | 1.90 | 1.88 | | 1.75 | 3:38 | 203.9 |
| -18 | 2.08 | 1.90 | 1.88 | 1.85 | 1.81 | | 1.75 | 2:30 | 140.1 |

### [Disclosure]

### [Technical Problem]

The present invention has been made in an effort to solve the problems occurring in the related art, and an object of the present invention is to provide a power monitoring system for a battery of an electro-mechanical apparatus which is capable of accurately monitoring a state of the battery by using a deviation in a terminal voltage of the battery and a charging efficiency.

In addition, another object of the present invention is to provide a power monitoring system for a battery of an electro-mechanical apparatus which is capable of monitoring a state of the battery by using a direction of a terminal current of the battery and wirelessly transmitting a state information of the battery and a driving information of the electro-mechanical apparatus.

Further, another object of the present invention is to provide a power monitoring system for a battery of an electro-mechanical apparatus which is capable of monitoring a state of the electro-mechanical apparatus by using a driving information of the electro-mechanical apparatus and a power consumption of the battery.

Moreover, another object of the present invention is to provide a power monitoring system for a battery of an electro-mechanical apparatus which is capable of judging inferiority and deterioration of the battery based on a temperature by using a relation between a measured terminal voltage of a cell and an external temperature.

### [Technical Solution]

In order to achieve the above object, the present invention provides a power monitoring system for a battery of an electro-mechanical apparatus, including: a measuring part measuring a characteristic value of each of a plurality of cells of the battery; a central processing part calculating an evaluation target value from the characteristic value and calculating a state information of the battery and a driving information of the electro-mechanical apparatus by comparing the evaluation target value and a first reference value; a wireless communicating part transmitting the state information and the driving information to an external management system; and a storing part storing the first reference value, the state information and the driving information.

In addition, the characteristic value may include one of a terminal voltage of each of the plurality of cells and a terminal current of each of the plurality of cells.

Further, the evaluation target value may include at least one of a deviation of a terminal voltage of each of the plurality of cells, a charging efficiency of the battery, a direction of a terminal current of each of the plurality of cells and a power consumption of the battery.

In addition, the evaluation target value may be the deviation of the terminal voltage of each of the plurality of cells, and the first reference value may be a reference deviation. When the deviation of the terminal voltage is smaller than the reference deviation, the central processing part may judge that the battery has a normal state, and when the deviation of the terminal voltage is equal to or greater than the reference deviation, the central processing part may judge that the battery has an abnormal state.

Further, the evaluation target value may be the charging efficiency of the battery, and the first reference value may be a reference efficiency range. When the charging efficiency is within the reference efficiency range, the central processing part may judge that the battery has a normal state, and wherein when the charging efficiency is out of the reference efficiency range, the central processing part may judge that the battery has an abnormal state.

In addition, the evaluation target value may be the direction of the terminal voltage of each of the plurality of cells, and the first reference value may be a reference direction which is a direction of a current of the battery discharged. When the direction of the terminal current is a same as the reference direction, the central processing part may judge that the electro-mechanical apparatus has a driving state, and when the direction of the terminal current is different from the reference direction, the central processing part may judge that the electro-mechanical apparatus is being charged.

Further, wherein when the central processing part judges that the electro-mechanical apparatus is being charged, the central processing part may transmit the state information and the driving information stored in the storing part to the external management system using the wireless communicating part.

In addition, the evaluation target value may be the power consumption of the battery, and the first reference value may be a reference power range. When the power consumption is within the reference power range, the central processing part may judge that the electro-mechanical apparatus has a normal state, and when the power consumption is out of the reference power range, the central processing part may judge that the electro-mechanical apparatus has an abnormal state.

Further, the state information may include an information on a normal state or an abnormal state of the battery, and the driving state may include at least one of a driving time, a driving distance and a driving path of the electro-mechanical apparatus.

In addition, the power monitoring system may further include a temperature sensing part sensing an external temperature of the battery, and the central processing part may select a second reference value corresponding to the external temperature and may judge a state of each of the plurality of cells by comparing the evaluation target value and the second reference value.

Further, the storing part may store a data on a plurality of second reference values corresponding to a plurality of external temperatures and a state information on a state of each of the plurality of cells.

In addition, the second reference value may be determined based on a change in discharging characteristic of each of the plurality of cells according to the external temperature.

Further, the evaluation target value may include at least one of a minimum terminal voltage and a maximum terminal voltage of each of the plurality of cells, a deviation of the minimum terminal voltage and the maximum terminal voltage (ripple), a discharging current and a discharging amount.

In addition, the evaluation target value may be the minimum terminal voltage of each of the plurality of cells, and the second reference value may be a reference voltage which decreases as the external temperature decreases. When the minimum terminal voltage is equal to or greater than the reference voltage, the central processing part may judge that the battery has a normal state, and when the minimum terminal voltage is smaller than the reference voltage, the central processing part may judge that the battery has an abnormal state.

Further, the evaluation target value may be the deviation of the minimum terminal voltage and the maximum terminal voltage of each of the plurality of cells, and the second reference value may be a reference deviation which increases as the external temperature decreases. When the deviation is equal to or smaller than the reference deviation, the central processing part may judge that the battery has a normal state, and wherein when the deviation is greater than the reference deviation, the central processing part may judge that the battery has an abnormal state.

In addition, the evaluation target value may be the discharging amount of each of the plurality of cells, and the second reference value may be a reference amount which decreases as the external temperature decreases. When the discharging amount is equal to or greater than the reference amount, the central processing part may judge that the battery has a normal state, and when the discharging amount is smaller than the reference amount, the central processing part may judge that the battery has an abnormal state.

### [Advantageous Effects]

In a power monitoring system for a battery of an electro-mechanical apparatus, since a state of the battery is accurately monitored by using a terminal voltage of the battery and a charging efficiency, a utilization efficiency of the battery is improved.

In addition, a state of the battery is monitored by using a direction of a terminal current of the battery, and a state information of the battery and a driving information of the electro-mechanical apparatus is wirelessly transmitted with a relatively low cost.

Further, a state of the electro-mechanical apparatus is monitored by using a driving information of the electro-mechanical apparatus and a power consumption of the battery.

Moreover, since a state of the battery is precisely monitored based on an external temperature even under an environment having a severe temperature change, a utilization efficiency of the battery is improved.

### [Description of Drawings]

FIG. 1 is a view showing a power monitoring system and an electro-mechanical apparatus according to a first embodiment of the present invention.
FIGs. 2A and 2B are views showing an evaluation target value and a reference value of a power monitoring system according to a first embodiment of the present invention.
FIG. 3 is a view showing a monitoring method of a power monitoring system according to a first embodiment of the present invention.
FIG. 4 is a view showing a power monitoring system and an electro-mechanical apparatus according to a second embodiment of the present invention.
FIG. 5 is a view showing an evaluation target value and a reference value of a power monitoring system according to a second embodiment of the present invention.
FIG. 6 is a view showing a monitoring method of a power monitoring system according to a second embodiment of the present invention.

### [Mode for Invention]

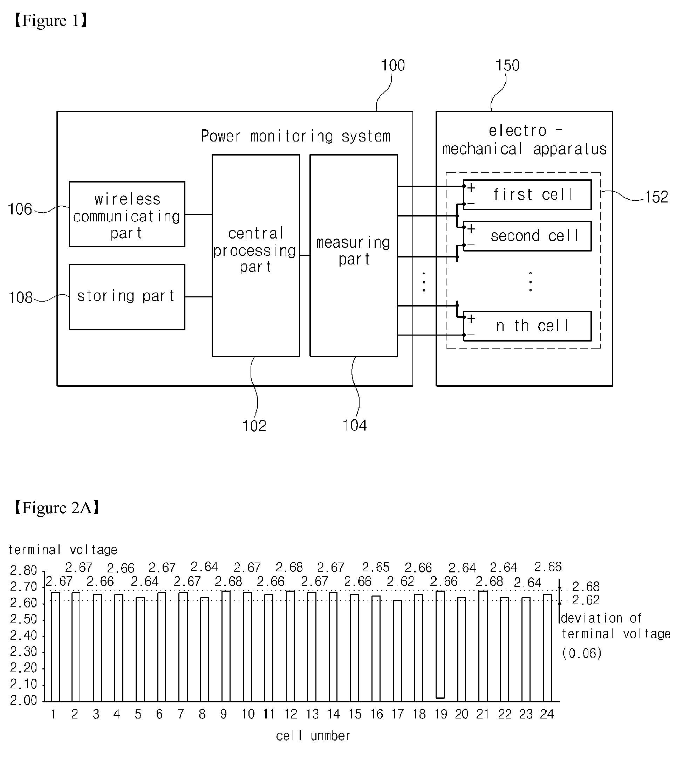

FIG. 1 is a view showing a power monitoring system and an electro-mechanical apparatus according to a first embodiment of the present invention.

In FIG. 1, a power monitoring system 100 according to a first embodiment of the present invention calculates a state information of a battery 152 and a driving information of an electro-mechanical apparatus 150 by monitoring a state of the battery 152 of the electro-mechanical apparatus 150 and transmits the state information of the battery 152 and the driving information of the electro-mechanical apparatus 150 to an external management system (not shown).

The power monitoring system 100 includes a central processing part 102, a measuring part 104, a wireless communicating part 106 and a storing part 108.

The electro-mechanical apparatus 150 includes the battery 152 having first to nth cells. The first to nth cells may be connected to each other in series, and the battery 152 may be connected to a charger (not shown) of a charging station to be charged by receiving a charging power from the charger or may be connected to the electro-mechanical apparatus 150 to be discharged by supplying a discharging power (power consumption).

The measuring part 104 is connected to an anode (+) terminal and a cathode (-) terminal of each of the first to nth cells of the battery 152 to measure a characteristic value of the anode (+) terminal and the cathode (-) terminal and to transmit the characteristic value to the central processing part 102.

For example, the characteristic value of the anode (+) terminal and the cathode (-) terminal may be one of a terminal voltage and a terminal current when the battery 152 is charged or discharged. The measuring part 104 may measure the terminal voltage (a charging voltage, a discharging voltage) or the terminal current (a charging current, a discharging current) of each of the first to nth cells of the battery 152 in real time.

The central processing part 102 controls operations of the wireless communicating part 106 and the storing part 108.

The central processing part 102 may calculate an evaluation target value of each of the first to nth cells of the battery 152 from the characteristic value of the measuring part 104 and may calculate a state information of the battery 152 and a driving information of the electro-mechanical apparatus 150 by comparing the evaluation target value with a stored reference value.

In addition, the central processing part 102 may store the state information of the battery 152 and the driving information of the electro-mechanical apparatus 150 in the storing part 108 and may transmit the state information of the battery 152 and the driving information of the electro-mechanical apparatus 150 to the external management system using the wireless communicating part 106 when the electro-mechanical apparatus 150 is judged to be being charged in a stop state at the charging station.

The evaluation target value may be at least one of a terminal voltage of each of the first to nth cells of the battery 152, a deviation in the terminal voltage of the first to nth cells of the battery 152, a charging efficiency of the battery 152, a direction of the terminal current of each of the first to nth cells of the battery 152 and a power consumption (discharging power) of the battery 152. The state information of the battery 152 may be an information on a normal state or an abnormal state of the battery 152. In addition, the driving information of the electro-mechanical apparatus 150 may be at least one of a driving time, a driving distance and a driving path.

The reference value means a value of a judgment reference for the normal state or the abnormal state of each of the first to nth cells of the battery 152. The reference value may be determined based on a change in a discharging property of each of the first to nth cells of the battery 152.

For example, when the evaluation target value is the terminal voltage of each of the first to nth cells of the battery 152, the reference value may be a reference voltage range. When the terminal voltage of each of the first to nth cells of the battery 152 is within the reference voltage range, each of the first to nth cells of the battery 152 may be judged as the normal state. When the terminal voltage of each of the first to nth cells of the battery 152 is out of the reference voltage range, each of the first to nth cells of the battery 152 may be judged as the abnormal state.

When the evaluation target value is the deviation in the terminal voltage of the first to nth cells of the battery 152, the reference value may be a reference deviation. When the deviation in the terminal voltage of the first to nth cells of the battery 152 is smaller than the reference deviation, the battery 152 may be judged as the normal state. When the deviation in the terminal voltage of the first to nth cells of the battery 152 is equal to or greater than the reference deviation, the battery 152 may be judged as the abnormal state.

As the charging and the discharging increase, the deviation in the terminal voltage of the first to nth cells increases by the nature of the battery 152. When the first to nth cells of the battery 152 have a relatively great deviation in the terminal voltage, some cells having a relatively high terminal voltage among the first to nth cells connected in series reach a final charging voltage and the other cells do not reach the final charging voltage. As a result, sulfation of the other cells is intensified to shorten the lifetime of the other cells. Accordingly, when the deviation in the terminal voltage is equal to or greater than the reference deviation, the battery 152 may be judged as the abnormal state.

When the central processing part 102 judges the battery 152 or each of the first to nth cells as the abnormal state using the terminal voltage or the deviation in the terminal voltage, the abnormal state may be informed to a user with a warning means such as an alarm or an emergency light, and the user may perform a low current charging where a relatively low current is used for a relatively long time or an equalizing charging where a constant voltage slightly higher than a voltage of a floating charging is used for a relatively long time so that the first to nth cells can have a uniform state.

In addition, when the evaluation target value is the charging efficiency of the battery 152, the reference value may be a reference efficiency range. When the charging efficiency of the battery 152 is within the reference efficiency range, the battery 152 may be judged as the normal state. When the charging efficiency of the battery 152 is out of the reference efficiency range, the battery 152 may be judged as the abnormal state.

The charging efficiency may be defined as a percentage of a discharging amount with respect to a charging amount (charging efficiency = (discharging amount/charging amount)* 100). The central processing part 102 may calculate the discharging amount and the charging amount of the battery 152 based on both of an opportunity charging and a regenerative braking charging and may calculate the charging efficiency from the discharging amount and the charging amount.

When the charging efficiency is out of the predetermined reference efficiency range even after the charging is completed by reaching the final charging voltage, the battery 152 may be regarded to have a problem. As a result, the battery 152 may be judged as the abnormal state when the charging efficiency of the battery 152 is out of the reference efficiency range.

When the central processing part 102 judges the battery 152 as the abnormal state using the charging efficiency, the abnormal state may be informed to a user with a warning means such as an alarm or an emergency light, and the user may check whether the battery 152 has the abnormality. When the battery 152 does not have the abnormality, the user may check whether the charger has the abnormality and may repair and maintain the charger.

In addition, when the evaluation target value is the direction of the terminal current of each of the first to nth cells of the battery 152, the reference value may be a reference direction which is a direction where the discharging current flows. When the direction of terminal current of each of the first to nth cells of the battery 152 is the same as the reference direction, the electro-mechanical apparatus 150 may be judged as a driving state. When the direction of terminal current of each of the first to nth cells of the battery 152 is different from the reference direction, the electro-mechanical apparatus 150 may be judged to be being charged in a stop state.

That the terminal current flows along a direction where the discharging current flows means that the electro-mechanical apparatus 150 is driven. As a result, when the direction of the terminal current of each of the first to nth cells of the battery 152 is the same as the reference direction, the electro-mechanical apparatus 150 may be judged as a driving state. That the terminal current flows along a direction different from a direction where the discharging current flows means that the electro-mechanical apparatus 150 is being charged. As a result, when the direction of the terminal current of each of the first to nth cells of the battery 152 is different from the reference direction, the electro-mechanical apparatus 150 may be judged to be being charged in a stop state at the charging station.

To sensing the direction of the terminal current, the power monitoring system 100 may include a current sensor (not shown), and the current sensor may be integrated in the measuring part 104.

When the central processing part 102 judges the electro-mechanical apparatus 150 as the driving state using the direction of the terminal current, the terminal voltage and the terminal current of the battery 152 may be recorded and stored as a discharging information, and a driving time, a driving distance and a driving path may be recorded and stored as a driving information. When the terminal current is not sensed while the discharging information and the driving information are recorded and stored, the electro-mechanical apparatus 150 may be judged to be temporarily stopped and the temporary stop may be reflected in the discharging information and the driving information.

In addition, when the central processing part 102 judges the electro-mechanical apparatus 150 to be being charged in the stop state, the terminal voltage and the terminal current of the battery 152 may be recorded and stored as a charging information, and the discharging information and the charging information of the battery 152 and the driving information of the electro-mechanical apparatus 150 may be transmitted to an external management system (not shown) using the wireless communicating part 106.

When the evaluation target value is the power consumption of the battery 152, the reference value may be a reference power range. When the power consumption of the battery 152 is within the reference power range, the electro-mechanical apparatus 150 may be judged as the normal state. When the power consumption of the battery 152 is out of the reference power range, the electro-mechanical apparatus 150 may be judged as the abnormal state.

When the power consumption of the battery 152 is out of the predetermined reference power range, a device of the electro-mechanical apparatus 150 such as a bearing of a driving portion or a brush of a motor may be regarded to have a problem. As a result, the electro-mechanical apparatus 150 may be judged as the abnormal state when the power consumption of the battery 152 is out of the reference power range.

The power consumption of the battery 152 may be an average power consumption based on the driving time of the electro-mechanical apparatus 150. The power consumption may be calculated by dividing a value integrating a transient power consumption with respect to the driving time by a total driving time, and the driving time may be calculated by excluding an elapsed time of the stop state of the electro-mechanical apparatus 150.

When the central processing part 102 judges the electro-mechanical apparatus 150 as the abnormal state using the power consumption, the abnormal state may be informed to a user with a warning means such as an alarm or an emergency light. The user may check whether the electro-mechanical apparatus 150 has the abnormality and may repair and maintain the electro-mechanical apparatus 150.

The wireless communicating part 106 transmits the state information of the battery 152 and the driving information of the electro-mechanical apparatus 150 stored in the storing part 108 to the external management system according to control of the central processing part 102 when the electro-mechanical apparatus 150 is judged to be being charged in the stop state in the charging station.

For example, the wireless communicating part 106 may be a free wireless personal area network module such as a Bluetooth and a Zigbee.

The storing part 108 stores the reference value used as a comparison reference for the evaluation target value in the central processing part 102 and stores the state information of the battery 150 and the driving information of the electro-mechanical apparatus 150 calculated by the central processing part 102.

The power monitoring system according to the first embodiment of the present invention where the state of the battery is judged using the terminal voltage or the deviation of the terminal voltage will be illustrated with reference to drawings.

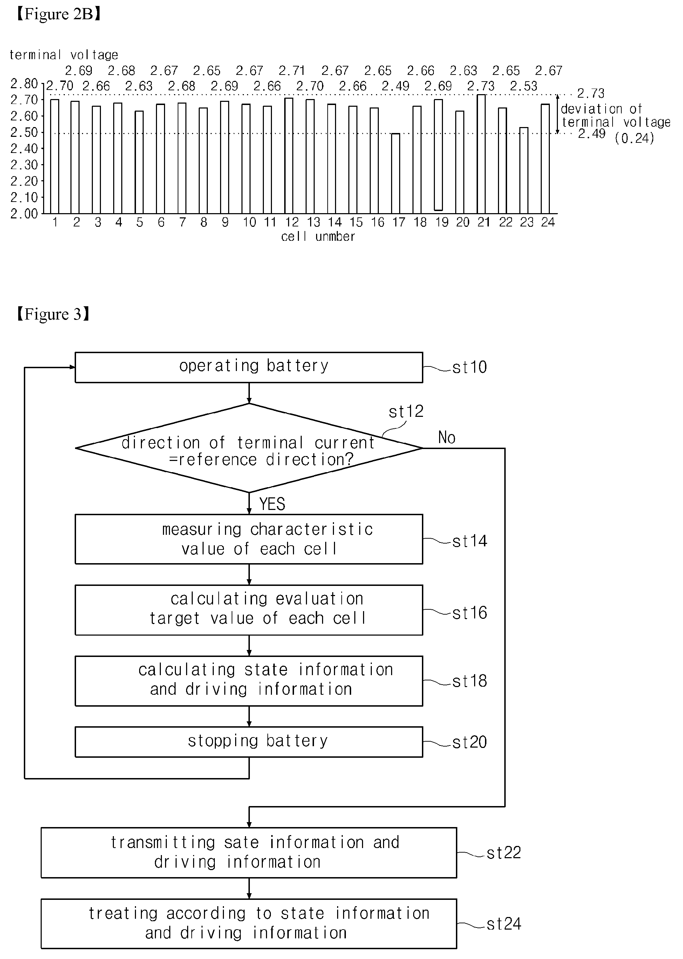

FIGs. 2A and 2B are views showing an evaluation target value and a reference value of a power monitoring system according to a first embodiment of the present invention. FIGs. 2A and 2B show a terminal voltage as the evaluation target value in a normal state and an abnormal state, respectively.

In FIGs. 2A and 2B, when a battery 152 including first to twenty-fourth cells each having a nominal voltage of about 2V is charged, a charger where a final charging voltage of each cell is set as about 2.5V and a final charging voltage of the whole battery 152 is set as about 60V may be used. When a terminal voltage of the battery 152 reaches the final charging voltage, operation of the charger may be stopped immediately or may be stopped after the further charging of about 1 hour to about 2 hours.

During the charging and the discharging, a deviation in the terminal voltage of the first to twenty-fourth cells is generated by the chemical nature of the battery 152.

Since the first to twenty-fourth cells are connected to each other in series, the final charging voltage of the battery 152 may be prematurely reached due to some cells having a relatively high terminal voltage during the charging and the other cells may have an insufficient charging state where the corresponding cells are not charged by the final charging voltage. The states of the first to twenty-fourth cells may be monitored through the terminal voltage or the deviation in the terminal voltage.

As shown in FIG. 2A, for the charger where a reference voltage range is set as from about 2.60V to about 2.70V and a reference deviation is set as about 0.10V, since the terminal voltage of each of the first to twenty-fourth cells is measured from about 2.62V to about 2.68V, the terminal voltages are within the reference voltage range. In addition, since the deviation in the terminal voltage of the first to twenty-fourth cells is measured as about 0.06V, the deviation in the terminal voltage is smaller than the reference deviation. As a result, the battery 152 of the first to twenty-fourth cells may be judged as a normal state.

As shown in FIG. 2B, since the terminal voltage of each of the first to twenty-fourth cells is measured from about 2.49V to about 2.73V, the terminal voltages are out of the reference voltage range. In addition, since the deviation in the terminal voltage of the first to twenty-fourth cells is measured as about 0.24V, the deviation in the terminal voltage is greater than the reference deviation. As a result, the battery 152 of the first to twenty-fourth cells may be judged as an abnormal state. A user may perform a low current charging or an equalizing charging so that the first to twenty-fourth cells can have a uniform state.

A monitoring method using the power monitoring system according to the first embodiment will be illustrated with reference to drawings.

FIG. 3 is a view showing a monitoring method of a power monitoring system according to a first embodiment of the present invention.

In FIG. 3, when an electro-mechanical apparatus 150 (of FIG. 1) begins to be driven, a battery 152 (of FIG. 1) is operated (st10), and a terminal voltage and a terminal current are generated in each of first to nth cells of the battery 152.

Next, a measuring part 104 (of FIG. 1) measures a direction of the terminal current of each of the first to nth cells of the battery 152 and compares the measured direction of the terminal current and a reference direction (st12).

Although the reference direction is exemplarily set as a direction where a discharging current flows in the first embodiment, the reference direction may be set as a direction where a charging current flows in another embodiment. The judgment result for the charging and the discharging of the battery 152 using the reference direction of the charging current is the same as the judgment result for the charging and the discharging of the battery 152 using the reference direction of the discharging current.

Next, as a comparison result, when the measured direction of the terminal current is the same as the reference direction, an electro-mechanical apparatus 150 (of FIG. 1) may be judged to be driven such that the battery 152 is being discharged. The measuring part 104 (of FIG. 1) measures a characteristic value of each of the first to nth cells of the battery 152 (st14) and transmits the measured characteristic value to a central processing part 102 (of FIG. 1).

For example, the measuring part 104 may measure the real-time terminal voltage (charging voltage, discharging voltage) of each of the first to nth cells of the battery 152 or the real-time terminal current (charging current, discharging current) as the characteristic value.

Next, the central processing part 102 calculates an evaluation target value of each of the first to nth cells of the battery 152 from the characteristic value (st16).

For example, the central processing part 102 may calculate at least one of the terminal voltage of each of the first to nth cells, the deviation in the terminal voltage of the battery 152, a charging efficiency of the battery 152 and a power consumption of the battery 152 as the evaluation target value.

Next, the central processing part 102 compares the calculated evaluation target value and the selected reference value, calculates a state information of the battery 152 and a driving information of the electro-mechanical apparatus 150 according to a comparison result (st18), and stores the calculated state information and the calculated driving information in a storing part 108 (of FIG. 1).

Next, when the driving of the electro-mechanical apparatus 150 is stopped, the operation of the battery 152 is stopped (st20). The stop of the driving of the electro-mechanical apparatus 150 may include a temporary stop during the driving and a stop for the charging in the charging station.

Next, when the driving is resumed or the charging begins, the battery 152 is operated again (st10), and the measuring part 104 measures the direction of the terminal current of each of the first to nth cells of the battery 152 and compares the measured direction of the terminal current and the reference direction (st12).

As the comparison result, when the measured direction of the terminal current is the same as the reference direction, measurement of the characteristic value (st14), calculation of the evaluation target value (st16) and calculation of the state information and the driving information (st18) are repeatedly performed.

As the comparison result, when the measured direction of the terminal current is different from the reference direction, the electro-mechanical apparatus 150 may be judged to enter the charging station and the battery 152 may be judged to be being charged. In addition, the central processing part 102 transmits the state information and the driving information stored in the storing part 108 to an external management system (st22).

Next, the user treats the battery 152, the electro-mechanical apparatus 150 or the charger according to the state information and the driving information (st24).

For example, when the state information and the driving information calculated by the terminal voltage or the deviation in the terminal voltage mean an abnormal state of the battery 152 or each of the first to nth cells of the battery 152, the user may perform a low current charging or an equalizing charging so that the first to nth cells can have a uniform state.

In addition, when the state information and the driving information calculated by the charging efficiency mean an abnormal state of the battery 152, the user may check whether the battery 152 has the abnormality. When battery 152 does not have the abnormality, the user may check whether the charger has the abnormality and may repair and maintain the charger.

Further, when the state information and the driving information calculated by the power consumption mean an abnormal state of the electro-mechanical apparatus 150, the user may check whether the electro-mechanical apparatus 150 has the abnormality and may repair and maintain the electro-mechanical apparatus 150.

In a power monitoring system for a battery of an electro-mechanical apparatus according to a first embodiment of the present invention, a driving of the electro-mechanical apparatus and a discharging of the battery or an entrance of the electro-mechanical apparatus and a charging of the battery are judged with reference to a direction of a terminal current of the battery in operation. When the battery is being discharged, the terminal voltage or a deviation in the terminal voltage, a charging efficiency and a power consumption are calculated and a state information of the battery and a driving information of the electro-mechanical apparatus are stored. When the battery is being charged, the state information and the driving information are transmitted to an external management system through a free wireless personal area network.

Accordingly, since a user manages the battery or the electro-mechanical apparatus according to the state information and the driving information, an accuracy of monitoring the state of the battery and the electro-mechanical apparatus is improved and a utilization efficiency of the battery is improved.

In a power monitoring system and an electro-mechanical apparatus according to a second embodiment of the present invention, a utilization efficiency is improved by monitoring a state of a battery according to a temperature.

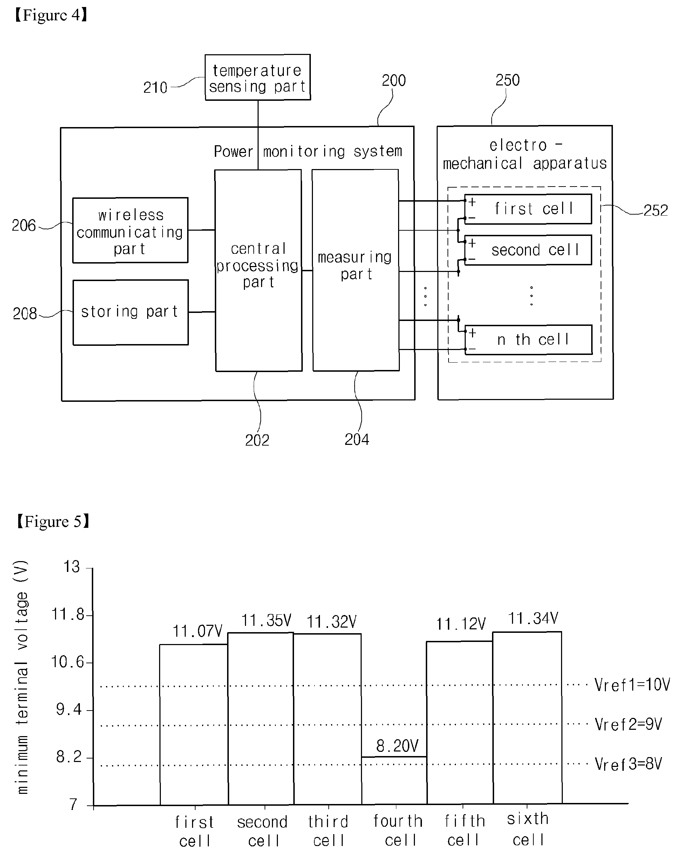

FIG. 4 is a view showing a power monitoring system and an electro-mechanical apparatus according to a second embodiment of the present invention. An illustration on a part of the second embodiment which is the same as a part of the first embodiment will be omitted.

In FIG. 4, a power monitoring system 200 according to a second embodiment of the present invention senses an external temperature and manages a battery 252 by judging a state of the battery 252 of an electro-mechanical apparatus 250 according to the sensed external temperature.

The power monitoring system 200 includes a central processing part 202, a measuring part 204, a wireless communicating part 206, a storing part 208 and a temperature sensing part 210.

The electro-mechanical apparatus 250 includes the battery 252 having first to nth cells. The first to nth cells may be connected to each other in series, and the battery 252 may be connected to a charger (not shown) of a charging station to be charged by receiving a charging power from the charger or may be connected to the electro-mechanical apparatus 250 to be discharged by supplying a discharging power (power consumption).

The measuring part 204 is connected to an anode (+) terminal and a cathode (-) terminal of each of the first to nth cells of the battery 252 to measure a characteristic value of the anode (+) terminal and the cathode (-) terminal and to transmit the characteristic value to the central processing part 102.

For example, the measuring part 204 may measure a real-time voltage (a charging voltage, a discharging voltage) or a real-time current (a charging current, a discharging current, a load current) of each of the first to nth cells of the battery 252 in real time.

The central processing part 202 controls operations of the measuring part 204, the wireless communicating part 206, the storing part 208 and the temperature sensing part 210.

The central processing part 202 may calculate an evaluation target value of each of the first to nth cells of the battery 152 from the characteristic value of the measuring part 204 and may calculate a state information of the battery 252 and a driving information of the electro-mechanical apparatus 250 by comparing the evaluation target value with a stored reference value.

In addition, the central processing part 202 may store the driving information of the state information of the battery 252 and the electro-mechanical apparatus 250 in the storing part 208 and may transmit the driving information of the state information of the battery 252 and the electro-mechanical apparatus 250 using the wireless communicating part 206 when the electro-mechanical apparatus 250 is judged to be being charged in a stop state at the charging station.

The evaluation target value may be at least one of a terminal voltage of each of the first to nth cells of the battery 252, a deviation in the terminal voltage of the first to nth cells of the battery 252, a charging efficiency of the battery 252, a direction of the terminal current of each of the first to nth cells of the battery 252, a power consumption (discharging power) of the battery 252, a minimum terminal voltage in a discharging, a maximum terminal voltage in a discharging, a deviation (ripple) between the minimum terminal voltage and the maximum terminal voltage in a discharging, a discharging current and a discharging amount (capacity).

Further, the measuring part 204 may convert the measured characteristic value into a voltage value within a treatable range and may transmit the converted voltage value to the central processing part 202. The central processing part 202 may convert an analog type of the transmitted characteristic value into a digital type and may calculate the evaluation target value.

The temperature sensing part 210 may be disposed at a periphery of the battery 252 of the electro-mechanical apparatus 250 to sense an external temperature and may transmit the sensed external temperature to the central processing part 202. When the power monitoring system 200 and the battery 252 are disposed adjacent to each other to have a relatively small temperature deviation, the temperature sensing part 210 may be integrated in the power monitoring system 200.

For example, the temperature sensing part 210 may include a thermistor, a thin film transistor (TFT) or another temperature sensor of various types.

The central processing part 202 may select a reference value corresponding to the external temperature transmitted from the temperature sensing part 210 and may judge a state of each of the first to nth cells of the battery 252 by comparing the selected reference value with the calculated evaluation target value.

The storing part 208 may store a plurality of reference values corresponding to a plurality of external temperatures as a look-up table shape and may transmit the reference value corresponding to the external temperature.

The reference value means a value of a judgment reference for the normal state or the abnormal state of each of the first to nth cells of the battery 252. The reference value may be determined based on a change in a discharging property of each of the first to nth cells of the battery 252.

For example, when the evaluation target value is the minimum terminal voltage of each of the first to nth cells of the battery 252, the reference value may be a reference voltage which decreases as the external temperature decreases. When the minimum terminal voltage is equal to or greater than the reference voltage, each of the first to nth cells of the battery 252 may be judged as the normal state. When the minimum terminal voltage of each of the first to nth cells of the battery 252 is smaller the reference voltage, each of the first to nth cells of the battery 252 may be judged as the abnormal state.

When the evaluation target value is the deviation between the minimum terminal voltage and the maximum terminal voltage of each of the first to nth cells of the battery 252, the reference value may be a reference deviation which increases as the external temperature decreases. When the deviation between the minimum terminal voltage and the maximum terminal voltage is equal to or smaller than the reference deviation, each of the first to nth cells of the battery 252 may be judged as the normal state. When the deviation between the minimum terminal voltage and the maximum terminal voltage is greater than the reference deviation, each of the first to nth cells of the battery 252 may be judged as the abnormal state.

When the evaluation target value is the discharging amount (capacity), the reference value may be a reference amount which decreases as the external temperature decreases. When the discharging amount is equal to or greater than the reference amount, each of the first to nth cells of the battery 252 may be judged as the normal state. When the discharging amount is smaller than the reference amount, each of the first to nth cells of the battery 252 may be judged as the abnormal state.

The central processing part 202 may store the state information on the normal state or the abnormal state of each of the first to nth cells of the battery 252 in the storing part 208 and may transmit the stored state information and the stored driving information to a battery treating part of a garage and so on wiredly or wirelessly.

The battery treating part may replace ones having the abnormal state among the first to nth cells according to the state information and the extracted cells may be recycled or discarded.

The power monitoring system according to the second embodiment of the present invention where the state of the batter is judged using the minimum terminal voltage will be illustrated with reference to drawings.

FIG. 5 is a view showing an evaluation target value and a reference value of a power monitoring system according to a second embodiment of the present invention.

In FIG. 5, a power monitoring system 200 (of FIG. 4) measures a characteristic value of each of first to nth cells of a battery 252 (of FIG. 4) of an electro-mechanical apparatus 250 (of FIG. 4) and calculates an evaluation target value from the characteristic value. The characteristic value may be a plurality of real-time terminal voltages of each of the first to nth cells of the battery 252 which is being discharged, and the evaluation target value may be a minimum terminal voltage which is a minimum value among the plurality of real-time terminal voltages.

For example, the minimum terminal voltages of the first to sixth cells may be about 11.07V, about 11.35V, about 11.32V, about 8.20V, about 11.12V and about 11.34V, respectively.

The reference voltage as a reference value for judging a normal state or an abnormal state of the first to sixth cells may be differently determined according to an external temperature sensed by a temperature sensing part 206 (of FIG. 4) based on a specification and a change in discharging characteristic of each of the first to nth cells of the battery 252.

For example, the reference voltages may be determined as 10V, 9V and 8V, respectively, for the external temperatures of about 25°C, about 0°C and about -18°C.

When the external temperature is within a range of about 25°C to about 0°C, the first to third cells, the fifth cell and the sixth cell having the minimum terminal voltage equal to or greater than the reference voltage of 10V or 9V may be judged as the normal state, and the fourth cell having the minimum terminal voltage smaller than the reference voltage of 10V or 9V as the abnormal state.

However, when the external temperature is about -18°C, all of the first to sixth cells having the minimum terminal voltage equal to or greater than the reference voltage of 8V may be judged as the normal state.

Accordingly, since the relatively low reference voltage compensated according to the external temperature is applied to the minimum terminal voltage of the fourth cell obtained under the relatively low external temperature, the state of the fourth cell is exactly judged.

A monitoring method using the power monitoring system according to the second embodiment will be illustrated with reference to drawings.

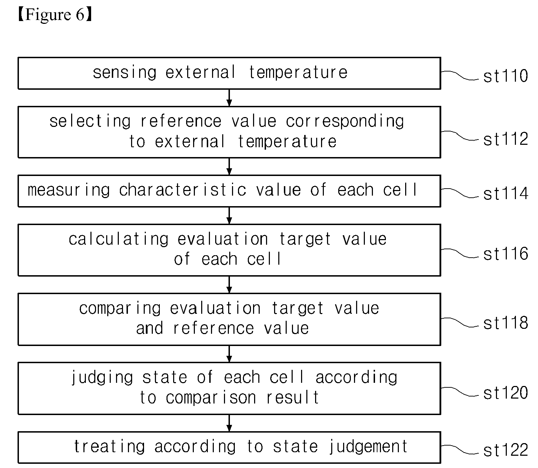

FIG. 6 is a view showing a monitoring method of a power monitoring system according to a second embodiment of the present invention.

In FIG. 6, a temperature sensing part 210 (of FIG. 4) senses an external temperature (st110) and transmits the sensed external temperature to a central processing part 202 (of FIG. 4).

Next, the central processing part 202 selects a reference value corresponding to the external temperature transmitted from the temperature sensing part 210 (st112). The central processing part 202 may select the reference value from a data on a plurality of reference values corresponding to a plurality of external temperatures in a storing part 208 (of FIG. 4).

A measuring part 204 (of FIG. 4) measures a characteristic value of each of first to nth cells of a battery 252 (of FIG. 4) (st114) and the measured characteristic value is transmitted to the central processing part 202. For example, the measuring part 204 may measure a real-time terminal voltage or a real-time terminal current of each of the first to nth cells of a battery 252 as the characteristic value.

Next, the central processing part 202 calculates an evaluation target value of each of the first to nth cells of the battery 252 from the characteristic value (st116).

For example, the central processing part 202 may calculate at least one of a minimum terminal voltage, a maximum terminal voltage, a deviation between the minimum terminal voltage and the maximum terminal voltage (ripple), a discharging current and a discharging amount (capacity) of each of the first to nth cells of the battery 252 as the evaluation target value.

Next, the central processing part 202 compares the calculated evaluation target value and the selected reference value corresponding to the external temperature (st118), and judges a state of each of the first to nth cells of the battery 252 according to a comparison result (st120).

Next, the central processing part 202 treats the corresponding cell according to a state information on a normal state or an abnormal state of each of the first to nth cells of the battery 252 (st122).

For example, the central processing part 202 may replace ones having the abnormal state among the first to nth cells of the battery 252 and the extracted cells may be recycled or discarded.

In a power monitoring system for a battery of an electro-mechanical apparatus according to a second embodiment of the present invention, a normal state or an abnormal state of the battery and a degree of deterioration of the battery according to a temperature are judged using a correlation of a measured voltage and a temperature reflecting a property of a battery voltage according to a temperature.

In addition, a battery state is judged using the correlation of a measured voltage and a temperature even when the battery state is judged using a minimum terminal voltage during operation.

Further, the battery state is judged using a deviation in a terminal voltage of the battery, and the state of the battery is checked using the minimum terminal voltage during operation of an electro-mechanical apparatus.

Moreover, the electro-mechanical apparatus is managed according to an external temperature based on a correlation of a discharging amount (capacity) according to a temperature.

## Claims

1. A power monitoring system for a battery of an electro-mechanical apparatus, comprising:
a measuring part measuring a characteristic value of each of a plurality of cells of the battery;
a central processing part calculating an evaluation target value from the characteristic value and calculating a state information of the battery and a driving information of the electro-mechanical apparatus by comparing the evaluation target value and a first reference value;
a wireless communicating part transmitting the state information and the driving information to an external management system; and
a storing part storing the first reference value, the state information and the driving information.

2. The power monitoring system of claim 1, wherein the characteristic value includes one of a terminal voltage of each of the plurality of cells and a terminal current of each of the plurality of cells.

3. The power monitoring system of claim 1, wherein the evaluation target value includes at least one of a deviation of a terminal voltage of each of the plurality of cells, a charging efficiency of the battery, a direction of a terminal current of each of the plurality of cells and a power consumption of the battery.

4. The power monitoring system of claim 3, wherein the evaluation target value is the deviation of the terminal voltage of each of the plurality of cells,
wherein the first reference value is a reference deviation,
wherein when the deviation of the terminal voltage is smaller than the reference deviation, the central processing part judges that the battery has a normal state, and
wherein when the deviation of the terminal voltage is equal to or greater than the reference deviation, the central processing part judges that the battery has an abnormal state.

5. The power monitoring system of claim 3, wherein the evaluation target value is the charging efficiency of the battery,
wherein the first reference value is a reference efficiency range,
wherein when the charging efficiency is within the reference efficiency range, the central processing part judges that the battery has a normal state, and
wherein when the charging efficiency is out of the reference efficiency range, the central processing part judges that the battery has an abnormal state.

6. The power monitoring system of claim 3, wherein the evaluation target value is the direction of the terminal voltage of each of the plurality of cells,
wherein the first reference value is a reference direction which is a direction of a current of the battery discharged,
wherein when the direction of the terminal current is a same as the reference direction, the central processing part judges that the electro-mechanical apparatus has a driving state, and
wherein when the direction of the terminal current is different from the reference direction, the central processing part judges that the electro-mechanical apparatus is being charged.

7. The power monitoring system of claim 6, wherein when the central processing part judges that the electro-mechanical apparatus is being charged, the central processing part transmits the state information and the driving information stored in the storing part to the external management system using the wireless communicating part.

8. The power monitoring system of claim 3, wherein the evaluation target value is the power consumption of the battery,
wherein the first reference value is a reference power range,
wherein when the power consumption is within the reference power range, the central processing part judges that the electro-mechanical apparatus has a normal state, and
wherein when the power consumption is out of the reference power range, the central processing part judges that the electro-mechanical apparatus has an abnormal state.

9. The power monitoring system of claim 1, wherein the state information includes an information on a normal state or an abnormal state of the battery, and
wherein the driving state includes at least one of a driving time, a driving distance and a driving path of the electro-mechanical apparatus.

10. The power monitoring system of claim 1, further comprising a temperature sensing part sensing an external temperature of the battery,
wherein the central processing part selects a second reference value corresponding to the external temperature and judges a state of each of the plurality of cells by comparing the evaluation target value and the second reference value.

11. The power monitoring system of claim 10, wherein the storing part stores a data on a plurality of second reference values corresponding to a plurality of external temperatures and a state information on a state of each of the plurality of cells.

12. The power monitoring system of claim 10, wherein the second reference value is determined based on a change in discharging characteristic of each of the plurality of cells according to the external temperature.

13. The power monitoring system of claim 12, wherein the evaluation target value includes at least one of a minimum terminal voltage and a maximum terminal voltage of each of the plurality of cells, a deviation of the minimum terminal voltage and the maximum terminal voltage (ripple), a discharging current and a discharging amount.

14. The power monitoring system of claim 13, wherein the evaluation target value is the minimum terminal voltage of each of the plurality of cells,
wherein the second reference value is a reference voltage which decreases as the external temperature decreases,
wherein when the minimum terminal voltage is equal to or greater than the reference voltage, the central processing part judges that the battery has a normal state, and
wherein when the minimum terminal voltage is smaller than the reference voltage, the central processing part judges that the battery has an abnormal state.

15. The power monitoring system of claim 13, wherein the evaluation target value is the deviation of the minimum terminal voltage and the maximum terminal voltage of each of the plurality of cells,
wherein the second reference value is a reference deviation which increases as the external temperature decreases,
wherein when the deviation is equal to or smaller than the reference deviation, the central processing part judges that the battery has a normal state, and
wherein when the deviation is greater than the reference deviation, the central processing part judges that the battery has an abnormal state.

16. The power monitoring system of claim 3, wherein the evaluation target value is the discharging amount of each of the plurality of cells,
wherein the second reference value is a reference amount which decreases as the external temperature decreases,
wherein when the discharging amount is equal to or greater than the reference amount, the central processing part judges that the battery has a normal state, and
wherein when the discharging amount is smaller than the reference amount, the central processing part judges that the battery has an abnormal state.
